# EUROPÄISCHE PATENTSCHRIFT

(11) **EP 2 802 678 B1**
(45) Veröffentlichungstag und Bekanntmachung des Hinweises auf die Patenterteilung: **16.03.2016**
(21) Anmeldenummer: 13700683.9
(22) Anmeldetag: 14.01.2013
(51) Int. Cl.: C23C 14/06, C23C 14/32, C23C 28/04, C23C 28/00, F16J 9/26, F16J 9/12

(54) **KOLBENRING**
PISTON RING
SEGMENT DE PISTON

(30) Priorität: 12.01.2012 DE 102012200378
(43) Veröffentlichungstag der Anmeldung: 19.11.2014
(73) Patentinhaber: Federal-Mogul Burscheid GmbH, 51399 Burscheid (DE)
(72) Erfinder: LAMMERS, Ralf, 42929 Wermelskirchen (DE); BAUER, Christiane, 51399 Burscheid (DE); FISCHER, Manfred, 42799 Leichlingen (DE); VETTER, Jörg, 51429 Bergisch Gladbach (DE)
(74) Vertreter: Mehler Achler
(86) Internationale Anmeldenummer: PCT/EP2013/050557
(87) Internationale Veröffentlichungsnummer: WO 2013/104784

(56) Entgegenhaltungen:
- EP-A2- 1 260 603
- DE-A1-102005 033 769
- DE-B3-102006 046 915
- DUCROS C ET AL: "Multilayered and nanolayered hard nitride thin films deposited by cathodic arc evaporation. Part 1: Deposition, morphology and microstructure", SURFACE AND COATINGS TECHNOLOGY, ELSEVIER, AMSTERDAM, NL, Bd. 201, Nr. 1-2, 12. September 2006 (2006-09-12), Seiten 136-142, XP024996452, ISSN: 0257-8972, DOI: 10.1016/J.SURFCOAT.2005.11.102 [gefunden am 2006-09-12]
- DUCROS C ET AL: "Multilayered and nanolayered hard nitride thin films deposited by cathodic arc evaporation. Part 2: Mechanical properties and cutting performances", SURFACE AND COATINGS TECHNOLOGY, ELSEVIER, AMSTERDAM, NL, Bd. 201, Nr. 3-4, 5. Oktober 2006 (2006-10-05), Seiten 1045-1052, XP024996088, ISSN: 0257-8972, DOI: 10.1016/J.SURFCOAT.2006.01.029 [gefunden am 2006-10-05]

## Beschreibung

Die Erfindung betrifft einen Kolbenring gemäß des Oberbegriffs des Anspruchs 1 und ein Verfahren zur Beschichtung eines Kolbenrings gemäß des Oberbegriffs des Anspruchs 11.

Hochbeanspruchte Gleitelemente in Kraft- und Arbeitsmaschinen, wie z. B. Kolbenringe, werden typischerweise mit Verschleißschutzschichten an der Lauffläche und/oder an den Ringflanken versehen, um die stetig weiter steigenden Ansprüche an die Lebensdauer erfüllen zu können. Höhere Zylinderdrücke, Direkteinspritzungen, Abgasrückführung und andere Konstruktionsmerkmale neuer Motorenentwicklungen wie alternative Zylinderwerkstoffe, neue Kraftstoffe, aber auch die Minimierung des Ölverbrauchs, erhöhen die Belastung der Kolbenringe. Im Sinne des Umweltschutzes und der zukünftigen Rohstoffsituation wird die Einsparung von Kraftstoffen zunehmend wichtiger. Eine wichtige Maßnahme zur Treibstoffreduzierung besteht in der Minimierung der Reibung im Motor. Weiterhin ist es im Sinne des Umweltschutzes und der vorgegebenen höheren Lebensdauern der Motoren wichtig, den Eigenverschleiß des Kolbenrings und besonders den Verschleiß der Zylinderlaufbahnen möglichst zu reduzieren, um die Abgasgrenzwerte einhalten zu können.

Gleitelemente werden bereits mit Verschleißschutzschichten versehen, die mittels thermischen Spritzverfahren, galvanischen Verfahren oder Dünnschichttechnologie aufgebracht oder durch Wärmebehandlung und Diffusionsprozesse gebildet werden. Diese Schichten werden über ihre Schichtdicke typischerweise umstrukturiert und weitgehend homogen aufgebracht.

Zur Minimierung des Verschleißes und zur Verbesserung der Risszähigkeit (Optimierung des Verhältnisses von Härte und Zähigkeit bzw. Duktilität) und Haftung dieser Schichten kommen verstärkt auch Viellagensysteme zum Einsatz.

Durch die geeignete Wahl der Einzellagendicken, die vom System abhängig ist, kann die Härte der Viellagenschicht höhere Werte erreichen als die Härten der Einzellagen. Auf Kolbenringe aufgebrachte Viellagenschichten aus Aluminiumnitrid und Chromnitrid besitzen sehr gute Verschleißeigenschaften (siehe DE 10 2006 046 917 A1) sowie gute Wärmeleiteigenschaften und damit gute Beständigkeit gegen Brandspurbildung und Fressen (siehe DE 10 2007 035 502 A1).

Die hohe Wärmeleitfähigkeit und damit die Fressbeständigkeit von Schichten, die Aluminiumnitrid enthalten, wird für optimales Verschleißverhalten der Schicht als Viellagenschicht mit Chromnitrid ausgeführt. Bei der serientauglichen Abscheidung durch kathodisches Lichtbogenverdampfen werden Aluminiumtropfen in diese Schichten eingebaut, wobei diese Tropfen als Droplets oder Schmelzspritzer bezeichnet werden.

In der DE 10 2007 035 502 A1 werden Legierungen mit einer Wärmeleitfähigkeit von mindestens 180 W/(m•K) offenbart. Derartige Legierungen dürfen nur sehr geringe Mengen an hochschmelzenden Komponenten in einer niedrigschmelzenden Komponente aufweisen. Diese bekannten Schichten weisen zwar gute thermische Leitfähigkeitswerte auf, allerdings finden sich in den Legierungen Droplets mit sehr großen Durchmessern, die überwiegend im Bereich von 15 bis 20 µm liegen. Die Wärmeleitfähigkeit einer mittels PVD-Verfahren aufgebrachten Schicht hängt nicht nur vom Werkstoff, sondern auch von der Schichtstruktur, Wachstumsdefekten und vom Dropletgehalt ab. Obwohl Titan eine Wärmeleitfähigkeit von 16 W/(m•K) und Aluminium eine Wärmeleitfähigkeit von 200 W/(m•K) aufweist, liegt die Wärmeleitfähigkeit z.B. von TiAI6V4 bei nur 6,3 W/(m•K) (bei einer Temperatur von 20°C).

Aus "Comparison of DC and AC arc thin film deposition techniques" in Surface and Coatings Techn. 120-121 (1999) 226-232 von Thomas Schülke et. al. ist es bekannt, die Dropletanzahl durch eine Filterung des Plasmas zu reduzieren bzw. die Dropletabscheidung auf dem Substrat zu verhindern.

In "Modified pulse arc deposition for reducing of droplet emission" in "IEEE 18th Int. Symp. On Discharges and Electrical Insulation in Vacuum-Eindhoven-1998 von K. Keutel et. al. wird zur Droplet-Reduzierung ein modifiziertes Puls-Bogen-Abscheideverfahren vorgeschlagen.

Aufgabe der Erfindung ist es, einen Kolbenring mit einer Verschleißschutzschicht zu schaffen, die sowohl einen geringeren eigenen Verschleiß aufweist als auch beim Gegenkörper einen geringeren Verschleiß verursacht. Es ist auch Aufgabe der Erfindung, ein Verfahren zur Herstellung einer solchen verbesserten Verschleißschutzschicht für Kolbenringe anzugeben.

Diese Aufgabe wird mit einem Kolbenring gemäß des Anspruchs 1 gelöst. Das Verfahren zur Herstellung einer solchen, hinsichtlich des Verschleißes verbesserten Verschleißschutzschicht ist Gegenstand des Anspruchs 16.

Eine Verschleißschutzschicht kann aus einer Einlagenschicht oder einer Viellagenschicht mit einer Vielzahl von Einzellagen bestehen.

Der Kolbenring weist eine Verschleißschutzschicht auf, die mindestens ein erstes niedrigschmelzendes Element besitzt, dessen Schmelzpunkt Tₘ ≤ 700°C beträgt. In dieser Schicht ist zusätzlich wenigstens ein zweites hochschmelzendes Element mit einem Schmelzpunkt Tₘ > 760°C enthalten. Der Schmelzpunkt des ersten niedrigschmelzenden Elements liegt vorzugsweise unter 700°C, vorzugsweise unter 600°C, insbesondere unter 500°C. Die Untergrenze für den Schmelzpunkt des ersten niedrigschmelzenden Elementes liegt bei 100°C.

Der Schmelzpunkt des zweiten hochschmelzenden Elements liegt vorzugsweise über 1000°C, besonders bevorzugt über 1400°C und insbesondere über 1500°C.

Bei den ersten und zweiten Elementen handelt es sich vorzugsweise um Metalle. Als zweite Elemente können auch Nichtmetalle, wie z. B. Si verwendet werden.

Außerdem sind in dieser Verschleißschutzschicht Droplets mit einem Durchmesser D vorhanden, die mindestens das niedrigschmelzende Element enthalten, wobei mindestens 90% der Droplets einen Wert 1 µm ≤ D ≤ 10 µm aufweist.

Es hat sich gezeigt, dass die Droplets die Rauheit erhöhen, so dass eine Nachbearbeitung erforderlich ist, um den Verschleiß auch des Gegenläufers zu reduzieren. Außerdem können bei Bearbeitung der Oberfläche oder beim Einsatz von Kolbenringen im Motor die betreffenden Stellen der Beschichtung ausbrechen. Es hat sich herausgestellt, dass die Größe der Droplets einen maßgeblichen Einfluss auf den Verschleiß einer Verschleißschutzschicht und eines Laufpartners hat.

Kleine Droplets, d. h. im Bereich von 1 µm ≤ D ≤ 10 µm sind von Vorteil. Durch eine Verkleinerung der Droplets kann der Aufwand für die Nachbearbeitung deutlich reduziert werden, weil die Rauheit mit abnehmender Dropletgröße ebenfalls abnimmt. Das Ausbrechen von Oberflächenbereichen, in denen Droplets zu finden sind, wird ebenfalls deutlich minimiert.

Ein weiterer Vorteil besteht darin, dass Droplets die Eigenspannungen einer Beschichtung abbauen, ohne einen schädigenden Einfluss auf den Schichtaufbau zu haben. Kleine Droplets führen zu dem positiven Effekt, dass Eigenspannungen in gewissem Maß abgebaut werden können. Werden in die Schichten größere Droplets eingebaut, kann ein größerer Teil der Eigenspannungen durch das größere Volumen der Droplets abgebaut werden. Allerdings haben große Droplets mit einem Durchmesser D > 10 µm den Nachteil, dass der Eigen- und der Gegenkörperverschleiß z. B. in einem Motor zunimmt. Durch die kleinen Droplets werden minimale Inhomogenitäten in der Beschichtung erzeugt, die zum Spannungsabbau beitragen.

Durch die Nachbearbeitung entstehen durch die kleinen Droplets Mikroschmiertaschen, die homogen verteilt sind.

Die Größenordnung der Mikroschmiertaschen sowie deren Verteilung beeinflussen in positiver Weise die tribologischen Eigenschaften der Beschichtung, was sich in geringerem Verschleiß insbesondere des Gegenkörpers, wie z. B. einer Zylinderlauffläche, äußert.

Der Durchmesser D der Droplets ist der Durchmesser der Einhüllenden der Droplets, wobei der Durchmesser D in einer Ebene senkrecht zur Substratnormalen gemessen wird.

Es ist bevorzugt, dass mindestens 90% der Droplets einen Wert 1 µm ≤ D < 8 µm, insbesondere einen Wert 1 µm ≤ D < 6 µm aufweisen.

Die Droplets lassen sich verfahrensbedingt nicht gänzlich verhindern, jedoch kann ihre Größe - wie im Zusammenhang mit dem erfindungsgemäßen Verfahren erläutert wird - gezielt eingestellt werden.

Es hat sich überraschend gezeigt, dass dann, wenn mindestens 90% der Droplets einen Wert D ≤ 10 µm aufweisen, der Verschleiß der Verschleißschutzschicht deutlich abnimmt. Der Verschleiß konnte um bis zu 50% gegenüber den Schichten mit Droplets, die außerhalb dieser Bedingung liegen, vermindert werden.

Vorzugsweise besteht das erste niedrigschmelzende Element aus Aluminium (Tₘ = 660°C). Aluminium hat den Vorteil, dass die Verschleißschutzschicht höhere Oxidationsbeständigkeit und eine hohe Wärmeleitfähigkeit aufweist. Weitere niedrigschmelzende Elemente sind Magnesium (Tₘ = 639°C), Zink (Tₘ = 420°C), Tellur (Tₘ = 449°C), Thallium (Tₘ = 303°C), Zinn (Tₘ = 232°C), Wismut (Tₘ = 271 °C) oder Schwefel (Tₘ = 113°C).

Vorzugsweise besteht das zweite hochschmelzende Element aus Titan (Tₘ = 1660°C), Vanadium (Tₘ = 1890°C), Chrom (Tₘ = 1875°C), Zirkonium (Tₘ = 1852°C), Niob (Tₘ = 2468°C), Molybdän (Tₘ = 2617°C), Hafnium (Tₘ = 2150°C), Tantal (Tₘ = 2996°C), Wolfram (Tₘ = 3390°C), Eisen (Tₘ = 1534°C), Silicium (Tₘ = 1410°C) oder Cer (Tₘ = 797°C).

Es hat sich gezeigt, dass die Dropletgröße insbesondere in Schichten, die aus mindestens einem Metallnitrid bestehen, einen wesentlichen Einfluss auf den Verschleiß solcher Schichten und deren Gegenläufer hat. Ein Metallnitrid umfasst auch Nitride aus zwei oder mehr Metallen.

Vorzugsweise besteht die Verschleißschutzschicht aus einer periodisch aufgebauten Viellagenschicht. Vorzugsweise besteht jede Periodizität aus mindestens zwei Einzellagen aus Metallnitriden. Es ist bevorzugt, dass alle Einzellagen der Viellagenschicht aus Nitriden bestehen.

Mindestens eine Einzellage jeder Periodizität weist mindestens eines der niedrigschmelzenden Elemente und mindestens eines der hochschmelzenden Elemente auf. Es hat sich gezeigt, dass eine Viellagenschicht aus Metallnitridschichten eine gute Verschleißbeständigkeit aufweist. In Verbindung mit der genannten Dropletgröße kann die Verschleißbeständigkeit noch verbessert werden.

Vorzugsweise weisen die Einzellagen Nitride mindestens eines Metalls aus der Gruppe Titan (Ti), Zirkonium (Zr), Hafnium (Hf), Vanadium (V), Niob (Nb), Tantal (Ta), Chrom (Cr), Molybdän (Mo), Wolfram (W), Eisen (Fe), Silicium (Si) oder Cer (Ce) auf.

Grundsätzlich sind alle Kombinationen der genannten ersten niedrigschmelzenden und zweiten hochschmelzenden Elemente möglich, wobei die Nitride dieser Kombinationen bevorzugt sind. Beispielsweise kann in einer Periodizität eine Einzellage aus einem Nitrid eines niedrigschmelzenden Elementes mit einer Einzellage aus einem Nitrid eines niedrigschmelzenden Elements und eines hochschmelzenden Elements kombiniert sein. Anstelle einer Einzellage aus einem Nitrid eines niedrigschmelzenden Elements kann auch eine Einzellage aus einem Nitrid eines hochschmelzenden Elements mit einer Einzellage aus einem Nitrid eines hoch- und eines niedrigschmelzenden Elements kombiniert werden. Dabei kann es sich um stöchiometrische Phasen oder um nichtstöchiometrische Phasen oder Mischungen daraus handeln. Z. B. soll unter CrN eine oder mehrere Phasen aus dem System Cr-N verstanden werden, analog gilt das für die anderen Systeme. Je nach Beschichtungsverfahren kann eventuell die eine oder andere Kombination bevorzugt sein.

Besonders bevorzugt ist die Verwendung von CrN für mindestens eine Einzellage der Periodizität. CrN-Einzellagen können im Viellagenschichtsystem mit Einzellagen der Nitride aller anderen Metalle der genannten Gruppen kombiniert werden.

Eine bevorzugte Einzellagenkombination in einer Periodizität ist CrN / AlTiN.

Vorzugsweise besteht die Periodizität der Viellagenschicht aus mindestens zwei Einzellagen aus AlTiN und CrN mit 47 bis 55 Gew.-% Cr, 19 bis 25 Gew.-% N, 10 bis 19 Gew.-% Al und 10 bis 14 Gew.-% Ti, wobei sich die Gew.-%-Angaben auf die Verschleißschutzschicht beziehen.

Ein eventuell vorhandener geringfügiger, als Verunreinigung anzusehender Sauerstoffanteil, der sich im Rahmen von wenigen At% bewegt, wurde nicht berücksichtigt.

Die Periodizität kann auch mehr als zwei Einzellagen, vorzugsweise bis zu vier Einzellagen aufweisen. Zwei Einzellagen sind insofern bevorzugt, weil der Herstellungsaufwand mit zunehmender Einzellagenanzahl pro Periodizität deutlich zunimmt.

Das hochschmelzende Element in einer Einlagenschicht bzw. einer Einzellage der Periodizität ist vorzugsweise mit einem Anteil von 1 bis 90 Gew.%, besonders bevorzugt von 20 bis 40 Gew.-% enthalten. Der Anteil des hochschmelzenden Elements hängt von den Schmelzpunkten der niedrig- und der hochschmelzenden Elemente ab.

Es hat sich gezeigt, dass je nach Art des hochschmelzenden Elements bereits geringe Mengen ausreichen, um die Dropletgröße deutlich zu verringern. Über den Anteil des hochschmelzenden Elements kann - für gleiche Verfahrensparameter - gezielt die Dropletgröße bzw. die Verteilung der Dropletgröße eingestellt werden. Je größer der Anteil des hochschmelzenden Elements im Vergleich zum Anteil des niedrigschmelzenden Elements ist, desto kleiner werden die Droplets und desto geringer ist die Anzahl der Droplets in der aufgebrachten Verschleißschutzschicht. Hierbei ist zu berücksichtigen, dass auch die Verfahrensparameter einen Einfluss auf die Dropletgröße haben.

Vorzugsweise wird die Verschleißschutzschicht mittels eines Lichtbogenverdampfungsverfahrens, vorzugsweise eines kathodischen Lichtbogenverdampfungsverfahrens, insbesondere eines filterlosen Lichtbogenverdampfungsverfahrens, aufgebracht. Das Verfahren ist vorzugsweise filterlos, d. h. es werden vor der Abscheidung keine Targetspritzer einer bestimmten Größe aussortiert.

Die Dicke einer Einzellage beträgt für den Aufbau der Schicht als Übergitterschicht vorzugsweise 5 nm bis 15 nm, besonders bevorzugt 8 nm bis 15 nm, insbesondere bevorzugt 10 nm bis 15 nm.

Die Dicke einer Einzellage beträgt für den Aufbau der Schicht als Viellagenschicht vorzugsweise 15 bis 500 nm, besonders bevorzugt 30 bis 200 nm, insbesondere bevorzugt 30 bis 80 nm.

Es hat sich gezeigt, dass es bezüglich der Verschleißbeständigkeit für jede Materialkombination der Einzellagen einen optimalen Wert für die Periodizität gibt.

Die Dicke der Verschleißschutzschicht beträgt vorzugsweise 10 µm bis 60 µm, besonders bevorzugt 20 µm bis 60 µm, und insbesondere 30 µm bis 40 µm.

Bevorzugte Verwendungen des erfindungsgemäßen Kolbenrings ist in Verbrennungsmotoren, insbesondere für Dieselmotoren oder Ottomotoren vorgesehen.

Das erfindungsgemäße Verfahren sieht vor, dass die Verschleißschutzschicht auf einem Substrat mittels eines Lichtbogenverdampfungsverfahrens, bei dem sich mindestens ein Targetmaterial in mindestens einem Target befindet, wobei dieses Targetmaterial verdampft wird, und in einer Gasatmosphäre auf dem Substrat abgeschieden wird, wobei das Targetmaterial mindestens ein erstes Element mit einem Schmelzpunkt Tₘ ≤ 700°C und mindestens ein zweites Element mit einem Schmelzpunkt Tₘ > 760°C aufweist, wobei das zweite Element in einer solchen Menge in dem Targetmaterial enthalten ist, dass der Schmelzpunkt des Targetmaterials Tₘ ≥ 1000°C beträgt.

Für das Verfahren ist es notwendig, dass sich das erste und das zweite Element im Gegensatz zum Stand der Technik gemeinsam in einem Target befinden, so dass beide Elemente gemeinsam verdampft bzw. aufgeschmolzen werden. Das Target ist beispielsweise eine aus dem Targetmaterial bestehende Materialplatte.

Es hat sich gezeigt, dass bereits geringe Mengen eines solchen zweiten Elements den Schmelzpunkt des legierten Targetmaterials signifikant anheben und dass bei einer hohen Schmelztemperatur des Targetmaterials weniger und kleinere Droplets gebildet werden, so dass über diese Parameter die gewünschte Dropletgröße bzw. deren Verteilung eingestellt werden kann.

Die Anteile des zweiten Elements im Targetmaterial des Targets beträgt vorzugsweise 1 bis 90 Gew.-%, besonders bevorzugt 40 bis 50 Gew.-%.

Das bevorzugte Lichtbogenverdampfungsverfahren ist ein kathodisches Lichtbogenverdampfungsverfahren. Dieses Verfahren hat den Vorteil, dass damit hohe Aufwachsraten erreicht werden können, die für eine industrielle Nutzung von Vorteil sind.

Als erstes Element wird vorzugsweise Aluminium verwendet. Andere erste Elemente sind: Magnesium, Zink, Tellur, Thallium, Zinn, Wismut oder Schwefel.

Als zweites Element wird vorzugsweise Titan verwendet. Weitere zweite Elemente können Vanadium, Chrom, Zirkonium, Niob, Molybdän, Hafnium, Tantal, Wolfram, Eisen, Silicium oder Cer sein, welche im Zusammenhang mit den erfindungsgemäßen Kolbenringen genannt wurden.

Vorzugsweise wird als Reaktivgas Stickstoff eingesetzt, um die Metallnitride zu erzeugen.

Der Druck des Reaktivgases wird vorzugswiese auf 1 bis 10 Pa eingestellt.

Vorzugsweise wird der Verdampferstrom auf 40 bis 200 A eingestellt.

Vorzugsweise wird die Vorspannung auf 5 bis 200 V eingestellt.

**Folgende Targetmaterial-Zusammensetzungen sind bevorzugt:**

| 1. Element | | 2. Element | bevorzugter Anteil | besonders bevorzugter Anteil |
|---|---|---|---|---|
| Al | Rest | Ti ≥ 1 Gew.-% | ≥ 2 Gew.-% | 40-50 Gew.-% |
| Al | Rest | V ≥ 3 Gew.-% | 3-50 Gew.-% | 3-4 Gew.% |
| Al | Rest | W ≥ 2 Gew.-% | 2-43 Gew.-% | 2-3 Gew.-% |
| Al | Rest | Zr ≥ 1 Gew.-% | 6-86 Gew.-% | 1-2 Gew.-% |
| Al | Rest | Fe ≥ 4 Gew.-% | 17-83 Gew.-% | 4-8 Gew.-% |
| Al | Rest | Fe ≥ 4 Gew.% | | 12-67 Gew.% |
| Al | Rest | Ce ≥ 20 Gew.-% | | 33-88 Gew.% |

Wenn die genannten Untergrenzen der Gewichtsanteile für das zweite Element eingehalten werden, wird die erfindungsgemäße Dropletgröße und Dropletverteilung erzielt.

Die Zusammensetzung der jeweils abgeschiedenen Schicht weicht in der Regel von der Zusammensetzung des Targetmaterials ab, weil einerseits durch das Reaktivgas z.B. Stickstoff als Nitrid in die Schicht eingebaut wird und andererseits durch die Wahl der Verfahrensparameter geringfügige Abweichungen verursacht werden können.

Im bevorzugten Beispiel mit Ti mit 40-50 Gew.-% und Rest Al wird eine Schmelztemperatur von ca. 1400°C erreicht, so dass bei einer Abscheidung mittels des Lichtbogenverdampfungsverfahrens zu Droplets führt, von denen mindestens 90% in einem Bereich in der Nähe der unteren Grenze des Wertebereichs 1 µm D ≤ 10 µm liegt. Targets mit dieser bevorzugten Zusammensetzung sind zu wirtschaftlich rentablen Kosten erhältlich.

Beispielhafte Ausführungsformen der Erfindung werden nachfolgend anhand der Zeichnungen näher erläutert.

### Es zeigen:

- Figur 1: einen Kolbenring in perspektivischer Darstellung,
- Figur 2: einen Schnitt längs der Linie II-II durch den in Figur 1 gezeigten Kolbenring,
- Figur 3: eine vergrößerte Darstellung der Einzelheit X aus Figur 2,
- Figur 4: eine vergrößerte Darstellung der Einzelheit Y aus Figur 3,
- Figuren 5 + 6: eine Draufsicht und einen Querschnitt durch ein Droplet,
- Figur 7: ein Schliffbild einer Beschichtung und eines Substrates mit 1000facher Vergrößerung, wobei die Beschichtung mittels einer Aluminiumkathode erfolgt ist,
- Figur 8: ein Schliffbild einer Beschichtung und eines Substrates mit 1000facher Vergrößerung, wobei die Beschichtung mittels einer AlTi-Kathode erfolgt ist,
- Figur 9: Diagramm, das die Häufigkeitsverteilung der Droplets zeigt,
- Figur 10: ein Diagramm, das die Summenhäufigkeit der Dropletverteilung zeigt,
- Figur 11: eine REM-Aufnahme einer Aluminiumnitrid-/Chromnitridschicht, in der die Chromdroplets in weiß und die Aluminiumdroplets in schwarz dargestellt sind,
- Figur 12: eine REM-Aufnahme einer Viellagenschicht, wobei die AIN-Lagen Titan enthalten,
- Figur 13: eine Draufsicht auf eine Aluminiumnitrid-/Chromnitridschicht mit Ausbrüchen nach der Oberflächenbearbeitung,
- Figur 14: eine Draufsicht auf eine Aluminiumtitannitrid-/Chromnitridschicht mit Ausbrüchen nach der Oberflächenbearbeitung,
- Figur 15: ein Diagramm, das die Verschleißwerte einer herkömmlichen AIN/CrN-Viellagenschicht im Vergleich zu einer erfindungsgemäßen AlTiN/CrN-Viellagenschicht zeigt,
- Figur 16: ein Diagramm, das die zugehörigen Zylinderverschleißwerte zeigt,
- Figur 17: ein Diagramm, das die Zylinderverschleißwerte nach einem Motor-lauf zeigt, und
- Figur 18: ein Diagramm, das die maximale Dropletgrößen in Abhängigkeit der Schmelztemperatur der verwendeten Materialien zeigt.

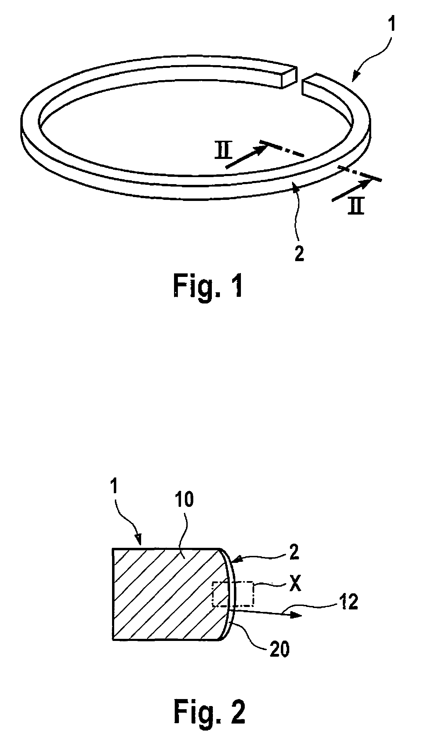

In der Figur 1 ist ein Kolbenring 1 perspektivisch dargestellt. Die Außenumfangsfläche bildet die Lauffläche 2.

In der Figur 2 ist ein Schnitt längs der Linie II-II durch den in Figur 1 gezeigten Kolbenring 1 dargestellt. Die Lauffläche 2 hat eine leicht ballige Form. Die auf dem Substrat 10 abgeschiedene Verschleißschutzschicht 20 bildet diese ballige Form ab.

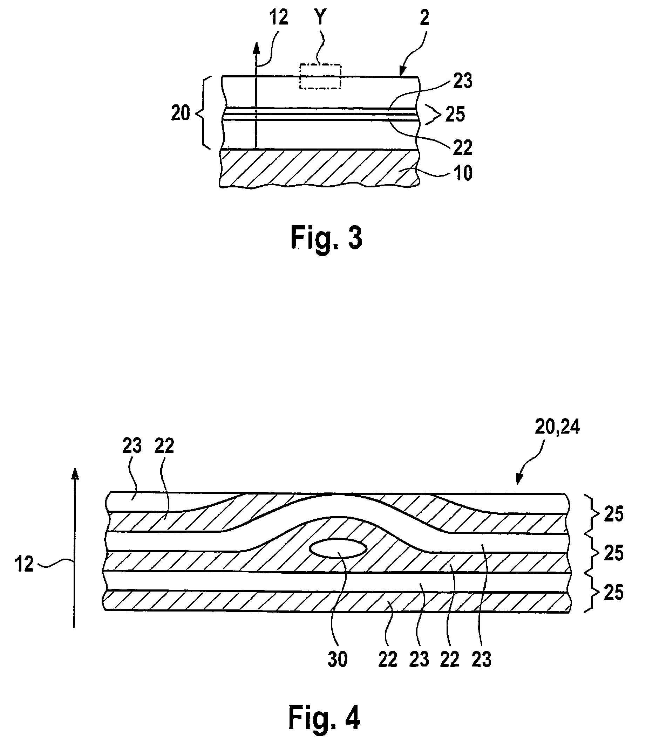

In der Figur 3 ist eine vergrößerte Darstellung der Einzelheit X aus der Figur 2 dargestellt. Auf dem Substrat 10 befindet sich eine Verschleißschutzschicht 20 aus einer Viellagenschicht, das aus einer Vielzahl von Periodizitäten 25 gebildet wird. Jede Periodizität 25 besteht aus zwei Einzellagen 22, 23, wobei der Übersichtlichkeit halber lediglich eine Periodizität 25 eingezeichnet ist.

In der Figur 4 ist eine vergrößerte Darstellung der Einzelheit Y aus Figur 3 dargestellt. In einer der Einzellagen 22 ist schematisch ein Droplet 30 eingezeichnet. Ein solches Droplet 30 bewirkt eine Aufwölbung der Schicht 32, die sich durch die weiteren darüber liegenden Einzellagen fortsetzt und teilweise verstärkt wird. Durch eine Oberflächenbearbeitung werden die oberen Einzellagen 22 und 23 angeschnitten, wodurch zwar die durch die Aufwölbung verursachte Oberflächenrauheit vermindert wird, aber aufgrund des Anschnitts Angriffsflächen entstehen, die über dem Droplet 30 zu Ausbrüchen des Beschichtungsmaterials führen können.

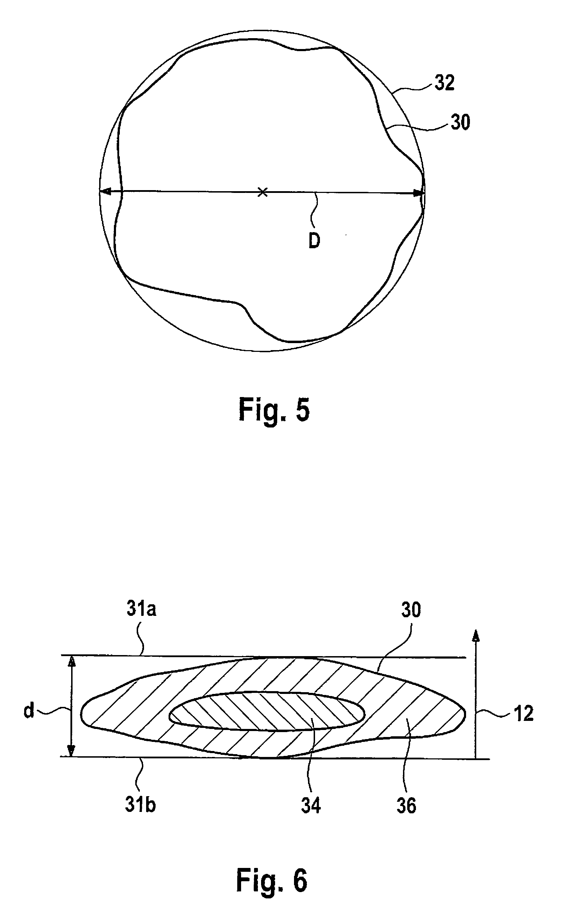

Ein Droplet ist in Draufsicht in der Figur 5 dargestellt. Es wird die Ebene gezeigt, die senkrecht auf der Substratnormalen 12 steht, die in den Figuren 3 und 4 eingezeichnet ist. Der Durchmesser D des Droplets 30 wird anhand des Hüllkreises 32 definiert.

In der Figur 6 ist ein Schnitt durch ein Droplet gemäß der Figur 5 dargestellt. Wenn beispielsweise Aluminiumnitrid für die Herstellung der betreffenden Schicht 22 der Figur 4 abgeschieden worden ist, weist das Droplet 30 einen Kern 34 aus Aluminium und eine Droplethülle 36 aus AIN auf. Die Dicke d wird über den Abstand der beiden Ebenen 31a, 31 b definiert, die senkrecht zur Substratnormalen 12 liegen und das Droplet begrenzen.

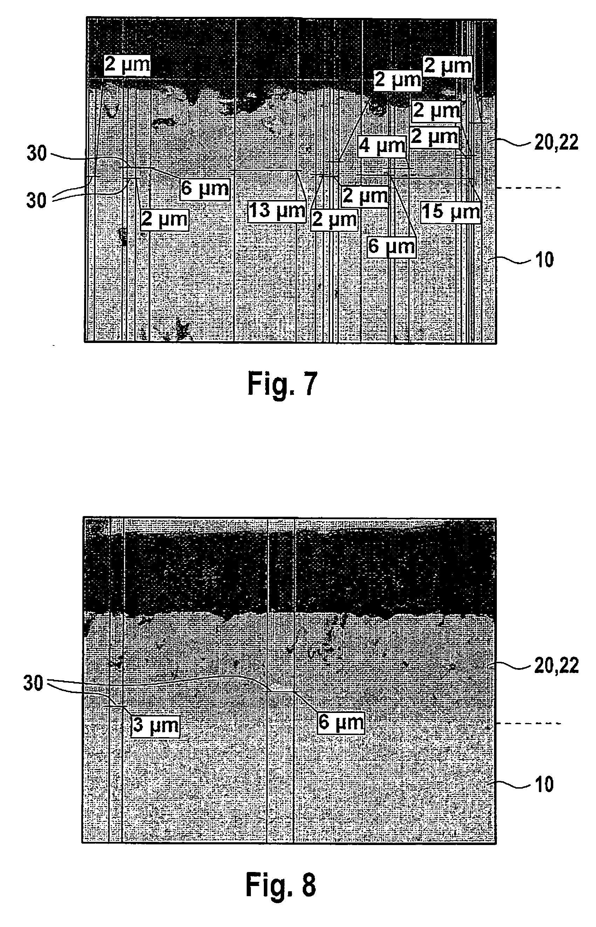

In der Figur 7 ist ein Substrat 10 mit einer darauf aufgebrachten Verschleißschutzschicht 20 gemäß des Standes der Technik dargestellt. Die Verschleißschutzschicht besteht aus einer Viellagenschicht. Die Verschleißschutzschicht 20 wurde mittels eines Lichtbogenverdampfungsverfahrens aufgebracht, wobei die beiden Kathoden (Targets) aus Chrom bzw. Aluminium bestehen. Die Schicht besteht aus AIN / CrN.

Es ist zu sehen, dass eine breite Verteilung von AIN-Droplets bezüglich deren Durchmesser D vorliegt, wobei einige Droplets einen Durchmesser von 13 bzw. 15 µm aufweisen. Außerdem sind CrN-Droplets vorhanden, die deutlich kleiner sind und somit vernachlässigt werden können.

Im Vergleich dazu ist in der Figur 8 ein Substrat 10 mit einer erfindungsgemäßen Verschleißschutzschicht 20 dargestellt, wobei die Verschleißschutzschicht aus einer Viellagenschicht mittels Lichtbogenverdampfung von Kathoden (Targets) hergestellt wurde. Das eine Target besteht aus Al und Ti, während das andere Target aus Cr besteht. Die Schicht 20 besteht aus TiAlN / CrN.

### Beschreibung des Beschichtungsverfahrens:

Das Lichtbogenverdampfen ist eine Form der PVD-Technik. Bei diesem Verfahren wird das Verdampfungsmaterial, das elektrisch leitfähig sein muss, als feste Platte (Target) in einer beliebigen Anordnung in eine Vakuum-Kammer eingebracht und als Kathode geschaltet. Durch Anlegen einer Spannung zwischen einer Anode und der Kathode entsteht ein Lichtbogen. Der Lichtbogen bewegt sich über die Kathode und verdampft dabei kleinste Mengen an Material. Die Verdampferleistung wird dabei durch den Verdampferstrom eingestellt. Aufgrund der hohen Energiedichte verdampft das Material direkt, ohne eine großflächige Schmelze zu bilden. Zwischen der Vakuumkammer und dem Substrat wird eine Vorspannung angelegt, wodurch die Metallionen in Richtung des zu beschichtenden Substrats beschleunigt werden. Dort reagieren die Metallionen mit einem eingeleiteten Reaktivgas (z. B. Stickstoff) und setzen sich als dünne nitridische Hartstoffschicht auf dem Substrat ab. Es bildet sich ein hochkonzentriertes Plasma in Form einer Dampfkeule, durch die das zu beschichtende Substrat geführt wird.

Es hat sich gezeigt, dass bestimmte Prozessbedingungen zu einem idealen Einbau der Droplets führen:
Strom
   - Anpassung der Entladebedingungen im Beschichtungsprozess bei Targets mit Durchmesser 100 mm: Verdampferströme: 40 bis 200 A Vorzugsweise liegen die Verdampferströme bei dieser Verdampfergeometrie bei 50 bis 150 A, insbesondere bei 80 bis 90 A. Bei sehr hohen Verdampferströmen kommt es durch eine Erhöhung der Kathodentemperatur zu Emissionen von größeren Droplets und die Anzahl der Droplets steigt. Bei sehr niedrigen Verdampferströmen wird der Verdampfungsprozess instabiler, so dass häufiger neu gezündet werden muss. Dies hat den Nachteil, dass große Droplets während der Zündphase emittiert werden.
Druck
   Reaktivgasdruck: 1 bis 10 Pa Stickstoff, vorzugsweise 2 bis 8 Pa.
   - Bei sehr niedrigen Reaktivgasdrücken 0,1 bis 0,9 Pa kommt es zu einer Emission von größeren Droplets und die Anzahl der Droplets steigt.
   - Bei sehr hohen Drücken >10 Pa bis 50 Pa werden die Ionen thermalisiert und die Schichtwachsrate ungünstig beeinflusst. Thermalisieren bedeutet die Anpassung der Teilchengeschwindigkeiten an die Umgebung durch Stöße.

Vorspannungen 5 bis 200 V, bevorzugt 5 bis 50 V, insbesondere 5 bis 20 V. Zum Ausführungsbeispiel:
Zusammensetzung des eingesetzten Targetmaterials:

**Target-Zusammensetzung**

| | At-% | Gew.-% |
|---|---|---|
| Al | 67 | 53,4 |
| Ti | 33 | 46,6 |

Die Schicht wurde als Viellagenschicht auf Kolbenringen abgeschieden:
- Aufbau: CrN / AlTiN
- Einzellagendicken zwischen 40 und 80 nm (Periodizitäten 80 - 160 nm)
- Elementzusammensetzung der Viellagenschicht (CrN- + AlTiN-Einzellagen)

| | At-% | Gew.-% |
|---|---|---|
| Cr | 24 - 28 | 47 - 55 |
| N | 52 - 57 | 19 - 25 |
| Al | 9 - 13 | 10 - 19 |
| Ti | 4 - 7 | 10 - 14 |
| O | 0 bis 3 | - |

Bei der Angabe in Gew.-% wurde der Sauerstoffgehalt vernachlässigt. Die Gew.-%-Angaben beziehen sich auf die Gesamtheit der Verschleißschutzschicht.

Eigenspannungen in den abgeschiedenen Schichten:
CrN / AIN: -0,94 GPa; CrN / ATiN: -1,08 GPa

Die Eigenspannungen in den abgeschiedenen Schichten sind mit großen Droplets (CrN / AIN) etwas geringer, da die größeren Droplets die Eigenspannungen in höherem Maße aufgrund des größeren Volumenanteils der Droplets abbauen können. Die Eigenspannungen werden mittels Röntgenbeugung an den abgeschiedenen Schichten nach dem sin² (Ψ)-Verfahren mittels Röntgeneugung gemessen. Ein negatives Vorzeichen gibt Druckeigenspannungen an.

Durch den Zusatz des Titans zu dem Targetmaterial Aluminium konnte eine deutliche Verringerung der Anzahl und auch der Durchmesser der Al-haltigen Droplets 30 erreicht werden. Beispielhaft sind zwei Droplets mit dem Durchmesser D von 3 µm und 6 µm gekennzeichnet.

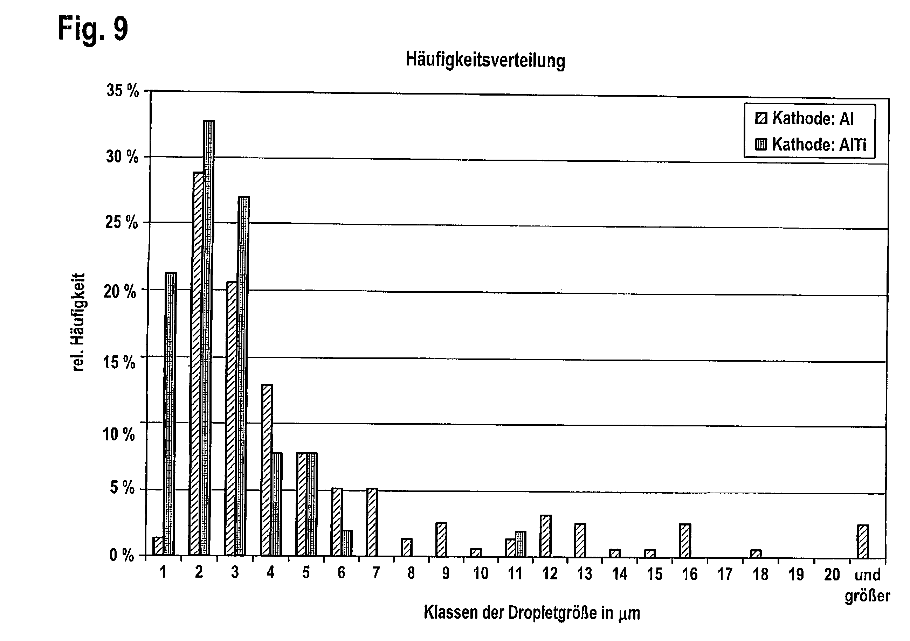

In der Figur 9 ist die Häufigkeitsverteilung der Droplets für die in den Figuren 7 und 8 gezeigten Schichten dargestellt. Es ist zu sehen, dass die AlN/CrN-Schicht auch einen verhältnismäßig großen Anteil von Droplets im Bereich > 10 µm enthält. Im Bereich unter 10 µm ist der Anteil der Droplets in der TiAlN/CrN-Schicht größer als in der AlN/CrN-Schicht. Die Häufigkeitsverteilung der Droplets hat sich durch die Zugabe von Titan zum Targetmaterial Aluminium deutlich verändert, was zu einer Verbesserung der Oberflächenrauheit und zu einer Verminderung des Verschleißes sowohl der Verschleißschutzschicht als auch des Gegenläufers führt.

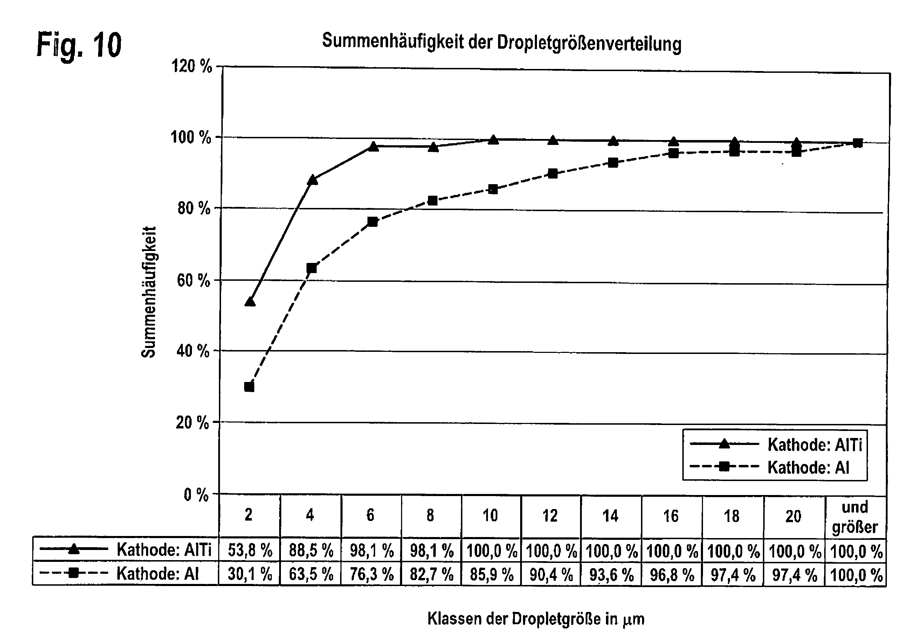

In der Figur 10 ist die dazugehörige Summenhäufigkeit aus der Figur 9 dargestellt. Es ist zu sehen, dass die Anzahl der Droplets mit einem Durchmesser D von ≤ 10 µm für die mit der AlTi-Kathode abgeschiedenen Schichten 100% beträgt und dass sogar der Anteil der Droplets mit einem Durchmesser D ≤ 6 µm immer noch bei 98,1 % und somit über 90% liegt.

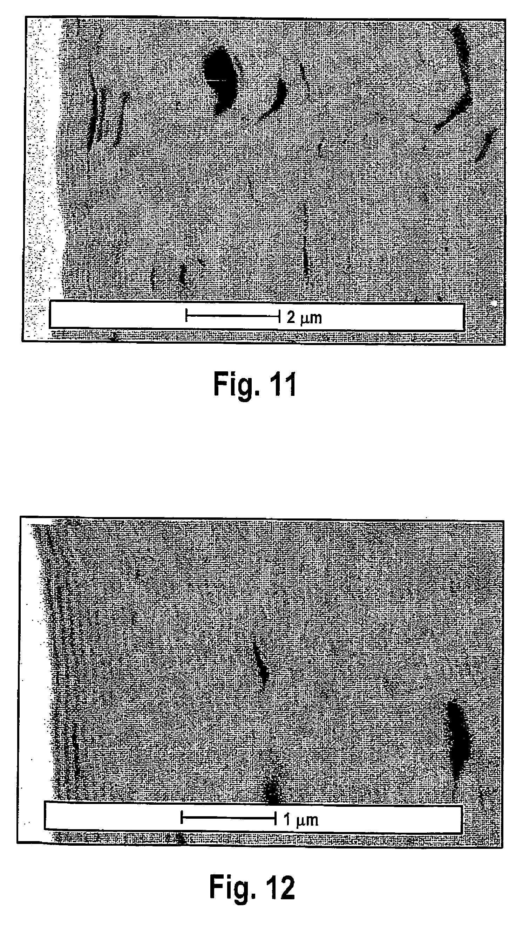

In den Figuren 11 und 12 sind REM-Aufnahmen dargestellt. Es ist zu erkennen, dass deutlich kleinere Aluminiumnitriddroplets in die Schicht eingebaut werden (Figur 12) im Vergleich zu den Schichten gemäß Figur 11. In den Darstellungen erscheinen die Chrom-Nitrid-Droplets weiß und die Aluminiumnitriddroplets in schwarz. Es ist zu sehen, dass durch die Zugabe von Titan eine Verringerung der Dropletgröße stattgefunden hat (siehe Figur 12).

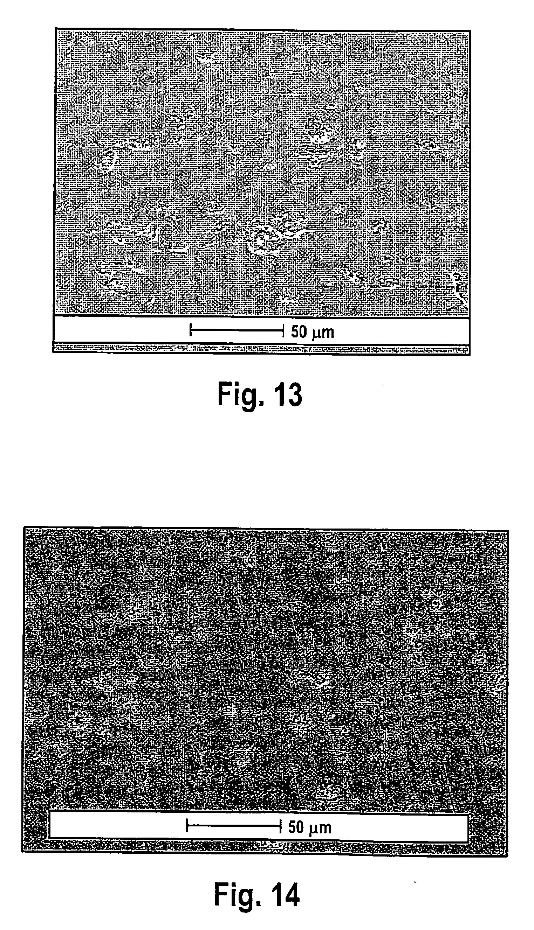

Dies führt zu deutlich glatteren endbearbeiteten Kolbenringlaufflächen, wie dies in den Figuren 13 und 14 dargestellt ist. Die Figur 13 zeigt die bearbeitete Oberfläche einer herkömmlichen Aluminiumnitrid/Chromnitridbeschichtung mit den Ausbrüchen nach der Bearbeitung. Die Ausbrüche sind kleiner und deutlich weniger, wenn dem Aluminium Titan zugegeben wird. In der Figur 14 ist ein Schichtsystem aus Aluminiumtitannitrid/Chromnitrid dargestellt. Es wird somit eine signifikante Verbesserung bezüglich der Ausbrüche erzielt.

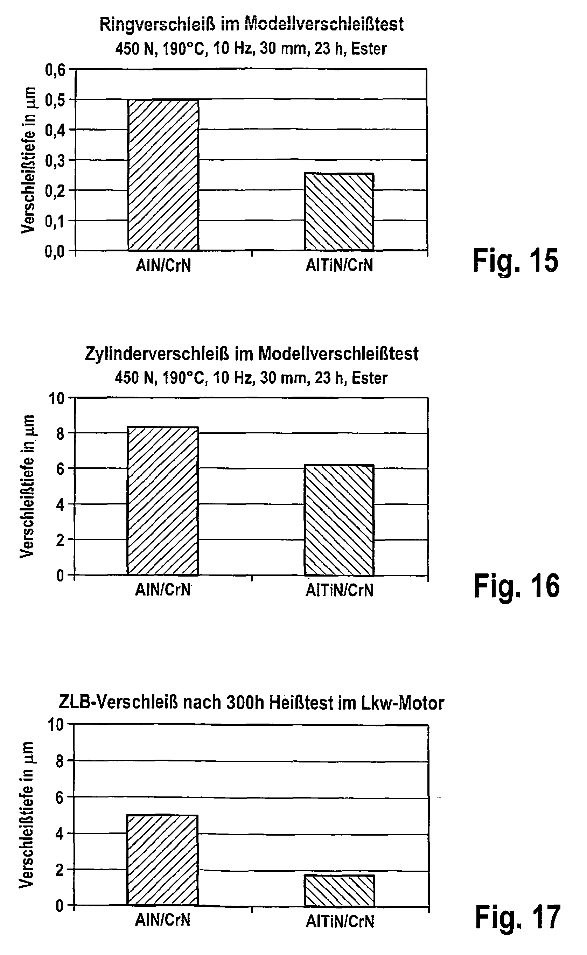

Als Folge zeigen Tribomodelltests (beschichtete Kolbenringsegmente gegen Segmente aus Zylinderlaufbuchsen) in den Figuren 15 und 16 sowohl einen geringeren Eigenverschleiß (Verschleiß des Kolbenrings in Figur 15) als auch einen geringeren Gegenkörperverschleiß (Zylinderverschleiß in Figur 16). Der Verschleiß am Kolbenring konnte um 50% und der Verschleiß am Zylinder um ca. 25% verringert werden.

Der Test wurde im Versuchsaufbau zur Untersuchung des oszillierenden Gleitverschleißes durchgeführt. Die Parameter sind: Normalkraft 450 N, Temperatur 190°C, Hub 30 mm, Dauer 23 h, Schmierstoff Ester.

Die Ergebnisse der Verschleißmessung an Zylinderlaufbuchsen (ZLB) nach einem 300 Stunden-Test in einem LKW-Motor unter verschärften Testbedingungen (hierunter ist zu verstehen: Das Kühlwasser wird auf 105°C statt ca. 90°C geregelt, der Motor wird über 9/10 Zeit mit maximalem Drehmoment, den Rest der Zeit mit Nennleistung betrieben) bestätigen die deutliche Verringerung des Gegenkörperverschleißes. Auch hier beträgt die Verschleißabnahme ca. 50%, wie Fig. 17 zeigt.

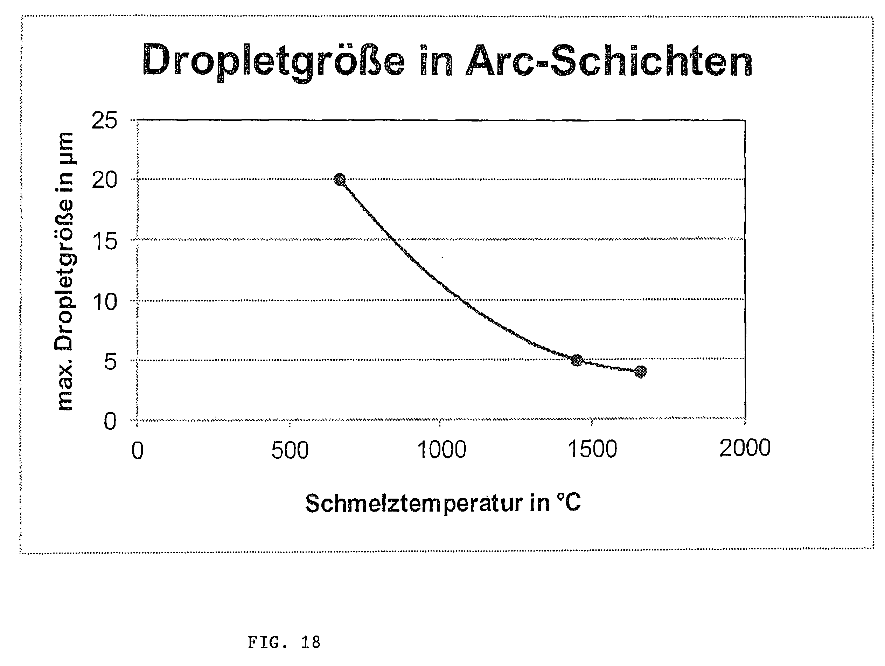

In der Figur 18 ist ein Diagramm zu sehen, das für das Lichtbogenverdampfungsverfahren die maximalen Dropletgrößen für Al (Schmelztemperatur 660°C), AlTi (50 Gew.-% Al, 50 Gew.-% Ti; Schmelztemperatur - 1500°C) und Ti (Schmelztemperatur 1660°C) zeigt. Mit zunehmendem Ti-Gehalt nimmt die Dropletgröße ab, wobei die Dropletgröße auch durch die Beschichtungsparameter des Lichtbogenverdampfungsverfahrens beeinflusst wird.

### Bezugszeichen liste

- 1: Kolbenring
- 2: Lauffläche

- 10: Substrat
- 12: Normale

- 20: Verschleißschutzschicht
- 22: Schicht
- 23: Schicht
- 24: Viellagenschicht
- 25: Periodizität

- 30: Droplet
- 31a,b: Ebene
- 32: Hüllkreis
- 34: Kernbereich
- 36: Droplethülle

## Patentansprüche

1. Kolbenring (1) mit einem Substrat (10) und einer darauf aufgebrachten Verschleißschutzschicht (20), die mindestens ein erstes Element aufweist, dessen Schmelzpunkt Tₘ ≤ 700°C beträgt, **dadurch gekennzeichnet,**
**dass** in der Verschleißschutzschicht (20) wenigstens ein zweites Element mit einem Schmelzpunkt Tₘ > 760°C enthalten ist, und
**dass** in der Verschleißschutzschicht (20) Droplets (30) mit einem Durchmesser D vorhanden sind, die mindestens das erste Element enthalten, wobei mindestens 90% der Droplets (30) einen Wert 1 µm ≤ D ≤ 10 µm aufweisen.

2. Kolbenring nach Anspruch 1, **dadurch gekennzeichnet,**
**dass** das erste Element Aluminium, Magnesium, Zink, Tellur, Thallium, Zinn, Wismut oder Schwefel ist.

3. Kolbenring nach einem der Ansprüche 1 oder 2 **dadurch gekennzeichnet, dass** das zweite Element Titan, Vanadium, Chrom, Zirkonium, Niob, Molybdän, Hafnium, Tantal, Wolfram, Eisen, Silicium oder Cer ist.

4. Kolbenring nach einem der Ansprüche 1 bis 3, **dadurch gekennzeichnet, dass** die Verschleißschutzschicht (20) aus mindestens einem Metallnitrid besteht.

5. Kolbenring nach einem der Ansprüche 1 bis 4, **dadurch gekennzeichnet, dass** die Verschleißschutzschicht (20) aus einer periodisch aufgebauten Viellagenschicht besteht, wobei jede Periodizität (25) aus mindestens zwei Einzellagen (22, 23) aus Metallnitriden besteht und mindestens eine Einzellage (22, 23) der Periodizität mindestens eines der niedrigschmelzenden Elemente und mindestens eines der hochschmelzenden Elemente aufweist.

6. Kolbenring nach Anspruch 5, **dadurch gekennzeichnet, dass** die Einzellagen (22, 23) Nitride mindestens eines Metalls aus der Gruppe Ti, Zr, HF, V, Nb, Ta, Cr, Mo und W aufweisen.

7. Kolbenring nach Anspruch 5 oder 6, **dadurch gekennzeichnet, dass** eine Einzellage (22, 23) der Periodizität aus AlTiN besteht.

8. Kolbenring nach einem der Ansprüche 5 bis 7, **dadurch gekennzeichnet, dass** eine Einzellage (22, 23) der Periodizität aus CrN besteht.

9. Kolbenring nach einem der Ansprüche 7 oder 8, **dadurch gekennzeichnet, dass** die Periodizität der Viellagenschicht aus mindestens zwei Einzellagen aus AlTiN und CrN mit 47bis 55 Gew.-% Cr, 19 bis 25 Gew.-% N, 10 bis 19 Gew.-% Al und 10 bis 14 Gew.-% Ti besteht, wobei sich die Gew.-%-Angaben auf die Verschleißschutzschicht (20) beziehen.

10. Kolbenring nach einem der Ansprüche 5 oder 6, **dadurch gekennzeichnet, dass** das zweite Element in einer Schicht (20-2) oder einer Einzellage (22, 23) der Periodizität (25) mit einem Anteil von 1 bis 90 Gew.-% enthalten ist.

11. Verfahren zur Herstellung einer Verschleißschutzschicht (20) mit Droplets auf einem Substrat (10) eines Kolbenrings gemäß Anspruch 1 mittels eines Lichtbogenverdampfungsverfahrens mit mindestens einem Target, das ein Targetmaterial aufweist, verdampft wird, und in einer Gasatmosphäre aus einem Reaktivgas auf dem Substrat abgeschieden wird, **dadurch gekennzeichnet,**
**dass** das Targetmaterial mindestens ein erstes Element mit einem Schmelzpunkt Tₘ ≤ 700°C und mindestens ein zweites Element mit einem Schmelzpunkt Tₘ > 760°C aufweist, wobei das zweite Element in einer solchen Menge in dem Targetmaterial enthalten ist, dass der Schmelzpunkt Tₘ des Targetmaterials Tₘ ≥ 1000°C beträgt.

12. Verfahren nach Anspruch 11, **dadurch gekennzeichnet,**
**dass** das Lichtbogenverdampfungsverfahren ein kathodisches Lichtbogenverdampfungsverfahren ist.

13. Verfahren nach einem der Ansprüche 11 oder 12, **dadurch gekennzeichnet, dass** ein Targetmaterial verwendet wird, bei dem der Anteil des zweiten Elements 1 bis 90 Gew.-% beträgt.

14. Verfahren nach einem der Ansprüche 11 bis 13, **dadurch gekennzeichnet, dass** als Reaktivgas Stickstoff eingesetzt wird.

15. Verfahren nach einem der Ansprüche 11 bis 14, **dadurch gekennzeichnet, dass** ein Target mit 40 bis 50 Gew.-% Ti und Rest Al verwendet wird.

## Claims

1. Piston ring (1) having a substrate (10) and a wear protection layer (20) which is applied thereto and which has at least a first element whose melting point Tₘ ≤ 700°C, **characterised in that**
at least a second element having melting point Tₘ > 760°C is contained in the wear protection layer (20), and
**in that** in the wear protection layer (20) there are present droplets (30) which have a diameter D and which contain at least the first element, wherein at least 90% of the droplets (30) have a value 1 µm ≤ D ≤ 10 µm.

2. Piston ring according to claim 1, **characterised in that** the first element is aluminium, magnesium, zinc, tellurium, thallium, tin, bismuth or sulphur.

3. Piston ring according to either claim 1 or claim 2, **characterised in that** the second element is titanium, vanadium, chromium, zirconium, niobium, molybdenum, hafnium, tantalum, tungsten, iron, silicon or cerium.

4. Piston ring according to any one of claims 1 to 3, **characterised in that** the wear protection layer (20) comprises at least one metal nitride.

5. Piston ring according to any one of claims 1 to 4, **characterised in that** the wear protection layer (2) comprises a periodically structured multi-ply layer, wherein each periodicity (25) comprises at least two individual layers (22, 23) of metal nitrides and at least one individual layer (22, 23) of the periodicity has at least one of the low-melting elements and at least one of the high-melting elements.

6. Piston ring according to claim 5, **characterised in that** the individual layers (22, 23) have nitrides of at least one metal from the group Ti, Zr, Hf, V, Nb, Ta, Cr, Mo and W.

7. Piston ring according to claim 5 or claim 6, **characterised in that** an individual layer (22, 23) of the periodicity comprises AlTiN.

8. Piston ring according to any one of claims 5 to 7, **characterised in that** an individual layer (22, 23) of the periodicity comprises CrN.

9. Piston ring according to either claim 7 or claim 8, **characterised in that** the periodicity of the multi-ply layer comprises at least two individual layers of AlTiN and CrN with from 47 to 55% by weight of Cr, from 19 to 25% by weight of N, from 10 to 19% by weight of Al and from 10 to 14% by weight of T, wherein the percentage by weight indications relate to the wear protection layer (20).

10. Piston ring according to either claim 5 or claim 6, **characterised in that** the second element is contained in a layer (20-2) or an individual layer (22, 23) of the periodicity at a proportion of from 1 to 90% by weight.

11. Method for producing a wear protection layer (20) with droplets on a substrate (10) of a piston ring according to claim 1 by means of an arc evaporation method, having at least one target, which has a target material, is evaporated, and is deposited on the substrate in a gas atmosphere of a reactive gas, **characterised in that**
the target material has at least a first element having a melting point Tₘ ≤ 700°C and at least a second element having a melting point Tₘ > 760°C, wherein the second element is contained in such a quantity in the target material that the melting point Tₘ of the target material Tₘ is ≥ 1000°C.

12. Method according to claim 11, **characterised in that** the arc evaporation method is a cathode arc evaporation method.

13. Method according to either claim 11 or claim 12, **characterised in that** there is used a target material in which the proportion of the second element is from 1 to 90% by weight.

14. Method according to any one of claims 11 to 13, **characterised in that** nitrogen is used as a reactive gas.

15. Method according to any one of claims 11 to 14, **characterised in that** a target with from 40 to 50% by weight of Ti and a balance of Al is used.

## Revendications

1. Segment de piston (1) comprenant un substrat (10) et une couche anti-abrasion (20) appliquée sur celui-ci, qui présente au moins un premier élément dont le point de fusion Tₘ est ≤ 700°C, **caractérisé en ce**
**que** la couche anti-abrasion (20) contient au moins un deuxième élément dont le point de fusion Tₘ est > 760°C, et
**que** dans la couche anti-abrasion (20) sont présentes des gouttelettes (30) d'un diamètre D qui contiennent au moins le premier élément, au moins 90 % des gouttelettes (30) présentant une valeur 1 µm ≤ D ≤ 10 µm.

2. Segment de piston selon la revendication 1, **caractérisé en ce que** le premier élément est l'un des éléments suivants : aluminium, magnésium, zinc, tellure, thallium, étain, bismuth ou soufre.

3. Segment de piston selon l'une des revendications 1 ou 2, **caractérisé en ce que** le deuxième élément est l'un des éléments suivants : titane, vanadium, chrome, zirconium, niobium, molybdène, hafnium, tantale, tungstène, fer, silicium ou cérium.

4. Segment de piston selon l'une des revendications 1 à 3, **caractérisé en ce que** la couche anti-abrasion (20) est constituée d'au moins un nitrure métallique.

5. Segment de piston selon l'une des revendications 1 à 4, **caractérisé en ce que** la couche anti-abrasion (20) est constituée d'une multicouche de structure périodique, chaque périodicité (25) étant constituée d'au moins deux couches individuelles (22, 23) en nitrures métalliques et au moins une couche individuelle (22, 23) de la périodicité présentant au moins un des éléments à bas point de fusion et au moins un des éléments à haut point de fusion.

6. Segment de piston selon la revendication 5, **caractérisé en ce que** les couches individuelles (22, 23) présentent des nitrures d'au moins un métal choisi dans le groupe formé par Ti, Zr, HF, V, Nb, Ta, Cr, Mo et W.

7. Segment de piston selon l'une des revendications 5 ou 6, **caractérisé en ce qu'**une couche individuelle (22, 23) de la périodicité est constituée de AlTiN.

8. Segment de piston selon l'une des revendications 5 à 7, **caractérisé en ce qu'**une couche individuelle (22, 23) de la périodicité est constituée de CrN.

9. Segment de piston selon l'une des revendications 7 ou 8, **caractérisé en ce que** la périodicité de la multicouche est constituée d'au moins deux couches individuelles en AlTiN et CrN avec 47 à 55 % en poids de Cr, 19 à 25 % en poids de N, 10 à 19 % en poids d'Al et 10 à 14 % en poids de Ti, les % en poids indiqués se rapportant à la couche anti-abrasion (20).

10. Segment de piston selon l'une des revendications 5 ou 6, **caractérisé en ce que** le deuxième élément est contenu dans une couche (20-2) ou une couche individuelle (22, 23) de la périodicité (25) dans une proportion de 1 à 90 % en poids.

11. Procédé de fabrication d'une couche anti-abrasion (20) comprenant des gouttelettes sur un substrat (10) d'un segment de piston selon la revendication 1 au moyen d'un procédé d'évaporation par arc électrique avec au moins une cible qui présente un matériau cible qui est vaporisé et déposé sur le substrat dans une atmosphère gazeuse composée d'un gaz réactif,
**caractérisé en ce**
**que** le matériau cible présente au moins un premier élément ayant un point de fusion Tₘ ≤ 700°C et au moins un deuxième élément ayant un point de fusion Tₘ > 760°C, le deuxième élément étant contenu dans le matériau cible dans une quantité telle que le point de fusion Tₘ du matériau cible est ≥ 1000°C.

12. Procédé selon la revendication 11, **caractérisé en ce**
**que** le procédé d'évaporation par arc électrique est un procédé d'évaporation par arc électrique cathodique.

13. Procédé selon l'une des revendications 11 ou 12, **caractérisé en ce que** le matériau cible utilisé contient le deuxième élément dans une proportion de 1 à 90 % en poids.

14. Procédé selon l'une des revendications 11 à 13, **caractérisé en ce que** le gaz réactif utilisé est de l'azote.

15. Procédé selon l'une des revendications 11 à 14, **caractérisé en ce que** la cible utilisée contient de 40 à 50 % en poids de Ti, le reste étant Al.
